# EUROPEAN PATENT APPLICATION

(11) **EP 4 764 283 A1**
(43) Date of publication of application: **24.06.2026**
(21) Application number: 25223818.3
(22) Date of filing: 16.12.2025
(51) Int. Cl.: F16L 27/11, F16L 51/02

(54) **BELLOWS JOINT FITTING, METHOD FOR TREATMENT OF PROCESS EXHAUST EFFLUENT, AND PROCESSING APPARATUS**

(30) Priority: 20.12.2024 US 202463737218 P
(71) Applicant: ASM IP Holding B.V., 1322 AP Almere (NL)
(72) Inventor: HONNIBALL, Kenneth, 1322 AP Almere (NL)
(74) Representative: V.O.

(57) **Abstract**

This disclosure relates to a bellows joint fitting, a method for treatment of process exhaust effluent, and a processing apparatus. The bellows joint fitting has an upstream end for accepting process exhaust effluent and a downstream end for discharging the process exhaust effluent. The bellows joint fitting comprises one or more fluid inlets for introducing dilution fluid to be discharged via the downstream end with the process exhaust effluent.

## Description

### TECHNICAL FIELD

This disclosure generally relates to joints or fittings for pipes. In particular, the present disclosure relates to joints provided with corrugated bellows and their use in maintaining the effective functioning of fluid exhaust installations, for example, in the field of semiconductor manufacturing.

### BACKGROUND

There has been wide interest in improving safety measures in the semiconductor industry, particularly concerning the handling of corrosive and toxic materials. The effects of these materials on equipment and personnel have received considerable attention due to the potential health risks and operational disruptions they pose.

It is generally accepted that process pumps in semiconductor manufacturing require flexible connections to accommodate alignment issues and reduce vibrational noise. Despite the importance of maintaining safe working environments, conventional solutions for managing exhaust gases have their limitations. Thin bellows structures in conventional adjustable pipe joints are prone to corrosion and rupture, potentially leading to hazardous leaks. In light of the above, it may be desirable to develop novel solutions related to enhancing the durability and safety of adjustable pipe joints.

Any discussion, including discussion of problems and solutions, set forth in this section has been included in this disclosure solely for the purpose of providing a context for the present disclosure. Such discussion should not be taken as an admission that any or all of the information was known at the time the invention was made or otherwise constitutes prior art.

### SUMMARY

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

According to a first aspect, a bellows joint fitting is provided. The bellows joint fitting has an upstream end for accepting process exhaust effluent and a downstream end for discharging the process exhaust effluent. The bellows joint fitting comprises a bellows pipe and one or more fluid inlets for introducing dilution fluid to be discharged via the downstream end with the process exhaust effluent.

According to a second aspect, a method for treatment of process exhaust effluent is provided. The method comprises providing a bellows joint fitting in accordance with the first aspect, accepting the process exhaust effluent into the bellows joint fitting via its upstream end, introducing dilution fluid into the bellows joint fitting via its one or more fluid inlets, and discharging the process exhaust effluent and the dilution fluid from the bellows joint fitting via its downstream end.

According to a third aspect, a processing apparatus is provided. The processing apparatus comprises a bellows joint fitting in accordance with the first aspect.

In some embodiments, the bellows joint fitting comprises an inner pipe coupled to and surrounded by the bellows pipe for shielding the bellows pipe from the process exhaust effluent.

In some embodiments, the bellows pipe has a first bellows pipe end, and the bellows joint fitting comprises an annular body connecting the first bellows pipe end to the inner pipe, at least part of the one or more fluid inlets extending inside the annular body.

In some embodiments, an annular intermediate space surrounded by the bellows pipe surrounds the inner pipe, and the one or more fluid inlets comprises one or more first fluid inlets configured to introduce the dilution fluid into the intermediate space.

In some embodiments, a fluid flow path surrounded by the inner pipe extends from the upstream end to the downstream end, and the one or more fluid inlets comprises one or more second fluid inlets configured to introduce the dilution fluid into the fluid flow path.

In some embodiments, accepting the process exhaust effluent comprises receiving the process exhaust effluent from a processing apparatus.

In some embodiments, the method comprises feeding the process exhaust effluent and the dilution fluid into an abatement unit.

In some embodiments, the method comprises measuring fluid conductance via at least part of the one or more fluid inlets to form a measurement result and, if the fluid conductance represented by the measurement result exceeds a pre-determined fluid conductance threshold value, raising an alarm and/or triggering an automated corrective procedure.

In some embodiments, the process exhaust effluent accepted into the bellows joint fitting comprises one or more inorganic acids in gaseous form.

In some embodiments, the dilution fluid comprises nitrogen gas.

In some embodiments, the processing apparatus comprises a dilution fluid source for providing the dilution fluid into the bellows joint fitting via the one or more fluid inlets thereof.

In some embodiments, the processing apparatus comprises a mass flow controller for controlling dilution fluid flow into the bellows joint fitting via the one or more fluid inlets thereof.

In some embodiments, the processing apparatus comprises one or more process units and an upstream exhaust network fluidically coupling the one or more process units and the bellows joint fitting for transporting process exhaust effluent from the one or more process units into the bellows joint fitting.

In some embodiments, the one or more process units comprises one or more chemical vapor deposition units, e.g., one or more atomic layer deposition units; and/or one or more dry etching units; and/or one or more diffusion furnace units.

In some embodiments, the processing apparatus comprises a vacuum pump upstream of the bellows joint fitting for driving the process exhaust effluent via the bellows joint fitting.

In some embodiments, the processing apparatus comprises an abatement unit and a downstream exhaust network fluidically coupling the bellows joint fitting and the abatement unit for transporting the process exhaust effluent from the bellows joint fitting to the abatement unit.

In some embodiments, the processing apparatus comprises a control unit configured to operate the processing apparatus for executing a method in accordance with the second aspect.

### DESCRIPTION OF THE DRAWINGS

A more complete understanding of the embodiments of the present disclosure may be derived by referring to the detailed description and claims when considered in connection with the following illustrative figures:
FIG. 1 illustrates a bellows joint fitting,
FIG. 2 shows a method for treatment of process exhaust effluent, and
FIG. 3 depicts a processing apparatus.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

The illustrations presented herein are not meant to be actual views of any particular material, structure, or device, but are merely idealized representations that are used to describe embodiments of the disclosure.

For clarity and brevity, consistent reference numerals may be used throughout the figures for corresponding, similar, and/or identical elements.

### DETAILED DESCRIPTION

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail or omitted entirely. Furthermore, the connecting lines shown in the various figures are intended to represent example functional relationships and/or physical couplings between the various elements. Many alternative or additional functional relationship or physical connections may be present in the practical system, and/or may be absent in some embodiments.

It is to be understood that the configurations and/or approaches described herein are examples in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and sub-combinations of the various processes, systems, and configurations, and other features, functions, acts, and/or properties disclosed herein, as well as any and all equivalents thereof.

In this specification, a "bellows pipe" may refer to a generally accordion-like and/or corrugated structure configured to expand and/or contract. Additionally or alternatively, a bellows pipe may refer to a structure configured to absorb vibrations and/or accommodate misalignments in a piping system. In some embodiments, a bellows pipe may consist of, consist substantially of, or comprise materials resistant to corrosion and/or capable of withstanding elevated temperatures and/or pressure differences. In some embodiments, a bellows pipe may consist of, consist substantially of, or comprise one or more stainless steels, such as 304 stainless steel, 321 stainless steel, 316L stainless steel, 317L stainless steel, or 904L stainless steel. Further, a "joint fitting" may refer to a component configured to connect sections of pipe or tubing in a fluid system, e.g., liquid, vapor, and/or gas system, and/or to provide flexibility and/or reduce stress on the connected components. In some embodiments, a joint fitting may comprise one or more types of connectors, such as couplings, elbows, tees, and/or adapters. Additionally or alternatively, a joint fitting may refer to a component configured to provide a secure and/or leak-proof connection between components. In some embodiments, a joint fitting may enhance durability and/or safety, for example, with features such as corrosion-resistant materials and/or reinforced structures. Consequently, a "bellows joint fitting" may refer to a joint fitting comprising a bellows pipe. Additionally or alternatively, a bellows joint fitting may refer to a joint fitting configured to connect sections of pipe or tubing while providing flexibility and/or reducing stress on the connected components. In some embodiments, a bellows joint fitting may have an upstream end for accepting process exhaust effluent and a downstream end for discharging the process exhaust effluent.

Throughout this disclosure, the term "end" may refer to a terminal position, boundary, or section of a component, section, or system. In some embodiments, an "end" may be configured to interface with other components, allowing for the transfer and/or containment of substances. Further, the term "upstream" may refer to a position or direction that is closer to a source or origin of a flow of fluid, e.g., liquid, vapor, and/or gas, and/or one or more other substances within a system. Additionally or alternatively, upstream may indicate a direction opposite to a fluid flow towards a final destination or discharge point. Consequently, the term "upstream end" may refer to an end that is suitable for of configured for positioning closer and/or closest to a source or origin of a flow of fluid, e.g., liquid, vapor, and/or gas, and/or one or more other substances. Additionally or alternatively, an upstream end may refer to an end where substances are to enter and/or are to be introduced into a component.

In this specification, the term "downstream" may refer to a position or direction that is positioned further along a flow path of a fluid, e.g., liquid, vapor, and/or gas, and/or one or more other substances within a system. Additionally or alternatively, "downstream" may indicate a direction in which substances are to be transported away from their source or origin. Consequently, the term "downstream end" may refer to an end that is suitable for or configured for positioning further along a flow path of fluid, e.g., liquid, vapor, and/or gas, and/or one or more other substances. Additionally or alternatively, a downstream end may refer to an end of a component where substances are to exit and/or are to be discharged from a component.

In this disclosure, the term "process" may refer to a series or group of actions or steps taken to achieve a particular end result in a manufacturing or treatment system or method. In some embodiments, a "process" may comprise one or more chemical, physical, and/or mechanical actions or steps. Further, the term "exhaust effluent" may refer to the waste fluid, e.g., waste liquid, waste vapor, and/or waste gas, expelled from an engine, machine, or industrial process. Additionally or alternatively, may refer to outflowing waste substances, such as waste fluid, e.g., waste liquid, waste vapor, and/or waste gas, from a process or system. In some embodiments, "exhaust effluent" may comprise by-products of chemical reactions and/or other industrial activities. Consequently, the term "process exhaust effluent" may refer to exhaust effluent expelled from a process or system. Additionally or alternatively, process exhaust effluent may refer to by-products of chemical reactions and/or other industrial activities to be discharged from a system. In some embodiments, process exhaust effluent may comprise one or more inorganic acids in gaseous form, e.g., as vapor and/or as gas, such as hydrochloric acid (HCl), hydrofluoric acid (HF), sulfuric acid (H₂SO₄), and/or nitric acid (HNO₃), and/or one or more other chemical compounds in any suitable form(s), e.g., as liquids, gases, and/or vapors.

Throughout this disclosure, a "control unit" may refer to a device or system possessing at least one designated function associated with determining and/or influencing one or more operational conditions, states, and/or parameters pertaining to another device, unit, or component. Additionally or alternatively, a control unit may refer to a device or system that receives one or more input signals from one or more sensors and/or generates one or more output signals to control one or more actuators. Additionally or alternatively, a control unit may refer to a device or system that executes one or more control algorithms to maintain desired process conditions for a processing apparatus. Additionally or alternatively, a control unit may refer to a device or system suitable or configured for controlling parameters such as temperature, pressure, gas flow rates, plasma power, and/or the like in a processing apparatus. Additionally or alternatively, a control unit may refer to a device or system that interfaces with an operator to allow manual adjustments of process parameters. In some embodiments, a control unit may be implemented as an electronic device. In some embodiments, a control unit may comprise hardware and/or software components. In some embodiments, a control unit may include a programmable logic controller (PLC) or a computer-based control system. In some embodiments, a control unit may be integrated with a data acquisition system to monitor and record process data. In some embodiments, a control unit may include safety interlocks to prevent unsafe operating conditions. In some embodiments, a control unit may form an integral part of a multifunction control system.

Further, the phrase "control unit configured to" execute a process may refer to the control unit being capable of, appropriate for, and/or adapted for executing the process. Additionally or alternatively, a control unit being configured to execute a process may also refer to any functionally described attributes of the control unit being executed, at least partially, by one or more hardware logic components. In some embodiments, a control unit may comprise at least one processor and at least one memory connected to the said processor. In some such embodiments, the memory may store program code instructions that, upon execution on the processor, prompt the processor to undertake a process that the control unit is configured to execute. In some embodiments, a control unit may comprise one or more hardware logic components. In some such embodiments, the one or more hardware logic components may include, for example, Field Programmable Gate Arrays (FPGAs), Application Specific Integrated Circuits (ASICs), Application Specific Standard Products (ASSPs), System on a Chips (SoCs), Complex Programmable Logic Devices (CPLDs), and the like. A control unit may generally function according to any suitable principles and via any suitable circuitry and/or signals recognized in the art.

In some embodiments, the presently described methods, devices, and apparatuses may be useful for joints and/or fittings for pipes. In some embodiments, the presently described methods, devices, and apparatuses may be useful for joints provided with corrugated bellows. In some embodiments, the presently described methods, devices, and apparatuses may be useful in the fields of microelectromechanical systems, microsystems, photonics, photovoltaics, display devices, and/or semiconductor manufacturing technology. In some embodiments, the presently described methods, devices, and apparatuses may be beneficial for maintaining the effective functioning of fluid exhaust installations. In some embodiments, they may be applied to forming fluid-tight joints in abatement unit, e.g., scrubber, forelines. In some embodiments, they may contribute to sustainable manufacturing practices in semiconductor production. In some embodiments, the presently described methods, devices, and apparatuses may be useful for extending the operational lifetime of fittings for pipes using dilution fluid to be added to process exhaust effluent to facilitate the abatement thereof.

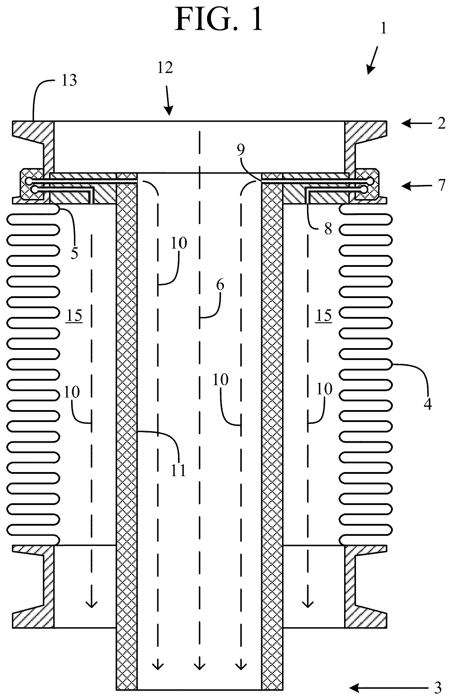

FIG. 1 shows a schematic lateral cross-sectional view of a bellows joint fitting 1 according to an embodiment. Unless explicitly stated otherwise, the bellows joint fitting 1 of the embodiment of FIG. 1 may or may not comprise any feature(s) disclosed within this specification, mutatis mutandis. Other embodiments may or may not be identical or similar to the embodiment of FIG. 1.

The bellows joint fitting 1 of the embodiment of FIG. 1 has an upstream end 2 for accepting process exhaust effluent 6 and a downstream end 3 for discharging the process exhaust effluent 6. The bellows joint fitting 1 comprises a bellows pipe 4 and one or more fluid inlets 7 for introducing dilution fluid 10 into the bellows joint fitting 1. The dilution fluid 10 introduced into the bellows joint fitting 1 is discharged via the downstream end 3 together with the process exhaust effluent 6. In some embodiments, such a bellows joint fitting may exhibit a lengthened operational lifetime. Additionally or alternatively, in some embodiments such a bellows joint fitting may reduce the probability of process exhaust effluent leakages. Additionally or alternatively, in some embodiments such a bellows joint fitting may facilitate early detection of leakages and/or timely maintenance of a processing apparatus provided with the bellows joint fitting. Additionally or alternatively, in some embodiments such a bellows joint fitting may reduce the need for extensive safety enclosures for detection and/or collection of leaked process exhaust effluent. Additionally or alternatively, in some embodiments such a bellows joint fitting may extend the operational lifetime of downstream devices and/or components. Additionally or alternatively, in some embodiments such a bellows joint fitting may facilitate abatement of process exhaust effluent, for example, via dilution thereof.

Each of the upstream end 2 and the downstream end 3 of the embodiment of FIG. 1 may be configured for fastening using a Klein Flansche (KF) clamp according to the ISO 2861:2020 standard. In other embodiments, an upstream end and/or a downstream end of a bellows joint fitting may be configured for fastening using any suitable means, e.g., using KF clamps, for example, according to the ISO 2861:2020 standard; using ISO-K claw clamps, ISO-F bolts, or half-clamps, for example, according to the ISO 1609:2020 standard; using metal conflat (CF) seals; or the like. In some embodiments, an upstream end and/or a downstream end may be configured for fluid-tight, e.g., liquid-tight and/or gas-tight, and/or vacuum-tight sealing.

The bellows pipe 4 of the embodiment of FIG. 1 may have a bellows wall thickness of about 0.2 mm or about 0.3 mm. In other embodiments, a bellows pipe may have any suitable bellows wall thickness, for example, a bellows wall thickness greater than or equal to 0.1 mm or to 0.2 mm and/or less than or equal to 0.4 mm or 0.5 mm.

The bellows pipe 4 of the embodiment of FIG. 1 may consist substantially of 304 stainless steel. In other embodiments, a bellows pipe may consist of, consist substantially of, or comprise any suitable material(s), such as one or more stainless steels, such as 304 stainless steel, 321 stainless steel, 316L stainless steel, 317L stainless steel, or 904L stainless steel.

In the embodiment of FIG. 1, the bellows joint fitting 1 comprises an inner pipe 11 coupled to and surrounded by the bellows pipe 4 for shielding the bellows pipe 4 from the process exhaust effluent 6. In some embodiments, a bellows joint fitting comprising such an inner pipe may exhibit a lengthened operational lifetime. In other embodiments, a bellows joint fitting may or may not comprise such an inner pipe.

The inner pipe 11 of the embodiment of FIG. 1 may have an inner pipe wall thickness of about 5 mm or about 0.7 mm. In other embodiments, an inner pipe may have any suitable inner pipe wall thickness, for example, an inner pipe wall thickness greater than or equal to 1 mm or to 2 mm and/or less than or equal to 1 cm or 2 cm. In some embodiments, wherein a bellows pipe has a bellows wall thickness, an inner pipe may have an inner pipe wall thickness greater than the bellows wall thickness.

The inner pipe 11 of the embodiment of FIG. 1 may consist substantially of 316L stainless steel. In other embodiments, an inner pipe may consist of, consist substantially of, or comprise any suitable material(s), such as one or more stainless steels, such as 304 stainless steel, 321 stainless steel, 316L stainless steel, 317L stainless steel, or 904L stainless steel. In some embodiments, wherein a bellows pipe consists of, consists substantially of, or comprises a bellows pipe material, an inner pipe may consist of, consists substantially of, or comprise an inner pipe material different to the bellows pipe material. In some such embodiments, the bellows pipe material may have a first corrosion resistance, and the inner pipe material may have a second corrosion resistance higher than the first corrosion resistance.

In the embodiment of FIG. 1, the bellows pipe 4 has a first bellows pipe end, the bellows joint fitting 1 comprises an annular body 13 connecting the first bellows pipe end to the inner pipe 11, and the one or more fluid inlets 7 extend inside the annular body 13. In some embodiments, wherein a bellows joint fitting comprises an annular body connecting a first bellows pipe end to an inner pipe, at least part of one or more fluid inlets extending inside the annular body may facilitate introducing dilution fluid into the bellows joint fitting. In other embodiments, a bellows joint fitting may or may not comprise an annular body connecting a first bellows pipe end to an inner pipe. In other embodiments, wherein a bellows joint fitting comprises an annular body connecting a first bellows pipe end to an inner pipe, at least part of one or more fluid inlets, e.g., one or more first fluid inlets and/or one or more second fluid inlets, may or may not extend inside the annular body. For example, in some embodiments a bellows joint fitting may comprise a perforated bellows pipe, comprising one or more through-holes acting as one or more fluid inlets, and the bellows joint fitting may be arranged inside a pressure chamber holding dilution fluid for driving the dilution fluid into the bellows joint fitting.

In the embodiment of FIG. 1, the annular body 13 is arranged towards the upstream end 2 from the bellows pipe 4. In other embodiments, wherein a bellows pipe has a first bellows pipe end and a bellows joint fitting comprises an annular body connecting the first bellows pipe end to an inner pipe, the annular body may be arranged in any suitable manner with respect to the bellows pipe, for example, towards an upstream end from the bellows pipe, towards a downstream end from the bellows pipe, or otherwise.

In the embodiment of FIG. 1, an annular intermediate space 15 surrounds the inner pipe 11, and the bellows pipe 4 surrounds the intermediate space 15. As such, the intermediate space 15 is arranged between the inner pipe 11 and the bellows pipe 4. The one or more fluid inlets 7 of the embodiment of FIG. 1 comprises one or more first fluid inlets 8 configured to introduce the dilution fluid 10 into the intermediate space 15. In some embodiments, one or more fluid inlets comprising one or more first fluid inlets configured to introduce dilution fluid into intermediate space surrounding an inner pipe may substantially lengthen the operational lifetime of a bellows joint fitting. Additionally or alternatively, one or more fluid inlets comprising one or more first fluid inlets configured to introduce dilution fluid into intermediate space surrounding an inner pipe may delay mixing between process exhaust effluent and the dilution fluid, which may, in turn, facilitate extending the operational lifetime of downstream devices and/or components. In other embodiments, an annular intermediate space surrounded by a bellows pipe may or may not surround an inner pipe. In embodiments, wherein an annular intermediate space surrounded by a bellows pipe surrounds an inner pipe, one or more fluid inlets may or may not comprise one or more first fluid inlets configured to introduce dilution fluid into the intermediate space.

The one or more first fluid inlets 8 of the embodiment of FIG. 1 may comprise, for example, a total of 4, 6, 8, 10, or 12 first fluid inlets. Individual first fluid inlets of the one or more first fluid inlets 8 may be radially distributed, for example, evenly radially distributed, along the extent of the annular body 13. In other embodiments, one or more first fluid inlets may comprise any suitable total number of individual first fluid inlets, for example, a total number of individual first fluid inlets greater than or equal to 2, or to 3, or to 4 and/or less than or equal to 6, or to 8, or to 10, or to 12. In other embodiments, individual first fluid inlets of one or more first fluid inlets may be arranged in any suitable manner with respect to one another, for example, along a closed, e.g., circular, elliptical, rectangular, or square, path, optionally with uniform spacings; radially distributed along the extent of an annular body, optionally with an even radial distribution; or otherwise.

In the embodiment of FIG. 1, a fluid flow path 12 surrounded by the inner pipe 11 extends from the upstream end 2 to the downstream end 3. The one or more fluid inlets 7 of the embodiment of FIG. 1 comprises one or more second fluid inlets 9 configured to introduce the dilution fluid 10 into the fluid flow path 12. In some embodiments, one or more fluid inlets comprising one or more second fluid inlets configured to introduce dilution fluid into such a fluid flow path may reduce deposit formation onto an inner pipe, which may, in turn, lengthen the operational lifetime of a bellows joint fitting. In other embodiments, a fluid flow path surrounded by an inner pipe may or may extend from an upstream end to a downstream end. In embodiments, wherein a fluid flow path surrounded by an inner pipe extends from an upstream end to a downstream end, one or more fluid inlets may or may not comprise one or more second fluid inlets configured to introduce dilution fluid into the fluid flow path.

The one or more second fluid inlets 9 of the embodiment of FIG. 1 may comprise, for example, a total of 4, 6, 8, 10, or 12 second fluid inlets. Individual second fluid inlets of the one or more second fluid inlets 9 may be radially distributed, for example, evenly radially distributed, along the extent of the annular body 13. In other embodiments, one or more second fluid inlets may comprise any suitable total number of individual second fluid inlets, for example, a total number of individual second fluid inlets greater than or equal to 2, or to 3, or to 4 and/or less than or equal to 6, or to 8, or to 10, or to 12. In other embodiments, individual second fluid inlets of one or more second fluid inlets may be arranged in any suitable manner with respect to one another, for example, along a closed, e.g., circular, elliptical, rectangular, or square, path, optionally with uniform spacings; radially distributed along the extent of an annular body, optionally with an even radial distribution; or otherwise.

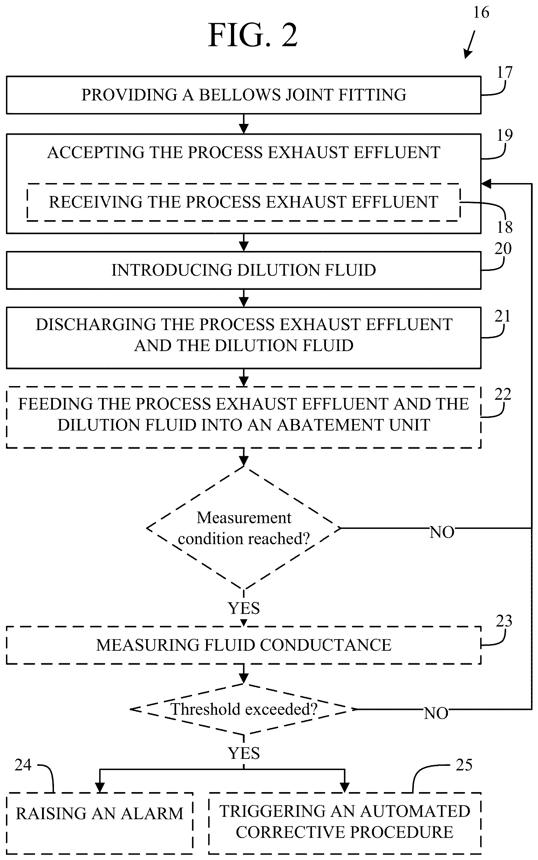

FIG. 2 schematically illustrates a method 16 for treatment of process exhaust effluent according to an embodiment. Unless explicitly stated otherwise, the method 16 of the embodiment of FIG. 2 may or may not comprise any feature(s) disclosed within this specification, mutatis mutandis. Other embodiments may or may not be identical or similar to the embodiment of FIG. 2.

The method 16 of the embodiment of FIG. 2 comprises providing a bellows joint fitting 17 in accordance with the first aspect, accepting the process exhaust effluent 19 into the bellows joint fitting via its upstream end, introducing dilution fluid 20 into the bellows joint fitting via its one or more fluid inlets, and discharging the process exhaust effluent and the dilution fluid 21 from the bellows joint fitting via its downstream end.

As indicated in FIG. 2 using dashed lines, the process of accepting the process exhaust effluent 19 of the embodiment of FIG. 2 may comprise receiving the process exhaust effluent 18 from a processing apparatus. In other embodiments, a process of accepting the process exhaust effluent may or may not comprise receiving the process exhaust effluent from a processing apparatus.

As again indicated in FIG. 2 using dashed lines, the method 16 of the embodiment of FIG. 2 may comprise feeding the process exhaust effluent and the dilution fluid into an abatement unit 22. In other embodiments, a method for treatment of process exhaust effluent may or may not comprise feeding the process exhaust effluent and the dilution fluid into an abatement unit.

Similarly, the method 16 of the embodiment of FIG. 2 may comprise measuring fluid conductance 23 via at least part of the one or more fluid inlets, e.g., via one or more first fluid inlets and/or via one or more second fluid inlets to form a measurement result. If the fluid conductance represented by the measurement result exceeds a pre-determined fluid conductance threshold value, the method 16 may further comprise raising an alarm 24 and/or triggering an automated corrective procedure 25, comprising, for example, an automated bellows joint fitting replacement procedure and/or an automated cleaning procedure, such as an automated dry cleaning procedure using one or more gaseous cleaning agents. In other embodiments, a method for treatment of process exhaust effluent may or may not comprise measuring fluid conductance via at least part of one or more fluid inlets, e.g., via one or more first fluid inlets and/or via one or more second fluid inlets to form a measurement result. In embodiments, wherein a method for treatment of process exhaust effluent comprises measuring fluid conductance via at least part of one or more fluid inlets, the method may or may not further comprise raising an alarm and/or triggering an automated corrective procedure, comprising, for example, an automated bellows joint fitting replacement procedure and/or an automated cleaning procedure, such as an automated dry cleaning procedure using one or more gaseous cleaning agents, for example, if the fluid conductance represented by the measurement result exceeds a pre-determined fluid conductance threshold value. Generally, a process of measuring fluid conductance may be conducted using any suitable methods and/or means. For example, in some embodiments measuring fluid conductance may comprise measuring fluid flow rate at a pre-determined pressure drop or pressure difference and/or measuring pressure drop or difference at a pre-determined fluid flow rate.

In the embodiment of FIG. 2, the process of measuring fluid conductance 23 may be executed if a pre-determined measurement condition has been reached. The measurement condition may comprise one or more sub-conditions, and one or more, for example, each, of such sub-conditions may need to be satisfied to trigger the process of measuring fluid conductance 23. For example, the one or more sub-conditions may comprise a first sub-condition for verifying that one or more, e.g., all, devices necessary and/or beneficial for measuring fluid conductance are operational, and/or a second sub-condition for verifying that the process of accepting the process exhaust effluent 19 is not operated during the process of measuring fluid conductance 23, and/or a third sub-condition for verifying whether an operator has triggered the process of measuring fluid conductance 23. In other embodiments, a process of measuring fluid conductance may or may not be executed if a pre-determined measurement condition has been reached. For example, in some embodiments a process of measuring fluid conductance may be executed repeatedly, continuously, or whenever possible. Generally, a process of measuring fluid conductance may or may not be executed concurrently with any other process(es), such as accepting the process exhaust effluent, introducing dilution fluid, and/or discharging the process exhaust effluent and the dilution fluid. In embodiments, wherein a process of measuring fluid conductance is executed if a pre-determined measurement condition has been reached, the measurement condition may or may not comprise one or more sub-conditions, and one or more, for example, each, of such sub-conditions may need to be satisfied to trigger the process of measuring fluid conductance. Such one or more sub-conditions may generally comprise any suitable sub-conditions, for example, a first sub-condition for verifying that one or more, e.g., all, devices necessary and/or beneficial for measuring fluid conductance are operational, and/or a second sub-condition for verifying that a process of accepting the process exhaust effluent is not operated during the process of measuring fluid conductance, and/or a third sub-condition for verifying whether an operator has triggered the process of measuring fluid conductance.

In the embodiment of FIG. 2, the process exhaust effluent accepted into the bellows joint fitting may comprise hydrochloric acid (HCl) and/or hydrofluoric acid (HF) in gaseous form. In other embodiments, process exhaust effluent accepted into the bellows joint fitting may comprise any suitable chemical compound(s), such as one or more inorganic acids, e.g., HCl, HF, sulfuric acid (H₂SO₄), and/or nitric acid (HNO₃), in any suitable form(s), e.g., as a liquid, as a gas, and/or as a vapor. For example, in some embodiments process exhaust effluent accepted into a bellows joint fitting may comprise one or more inorganic acids in gaseous form, e.g., as a gas and/or as a vapor.

In the embodiment of FIG. 2, the dilution fluid may comprise nitrogen gas (N₂). In other embodiments, dilution fluid may or may not comprise nitrogen gas. For example, in some embodiments, dilution fluid may comprise argon (Ar), helium (He), carbon dioxide (CO₂), hydrogen (H₂), and/or oxygen (O₂) in addition to or as an alternative to nitrogen gas.

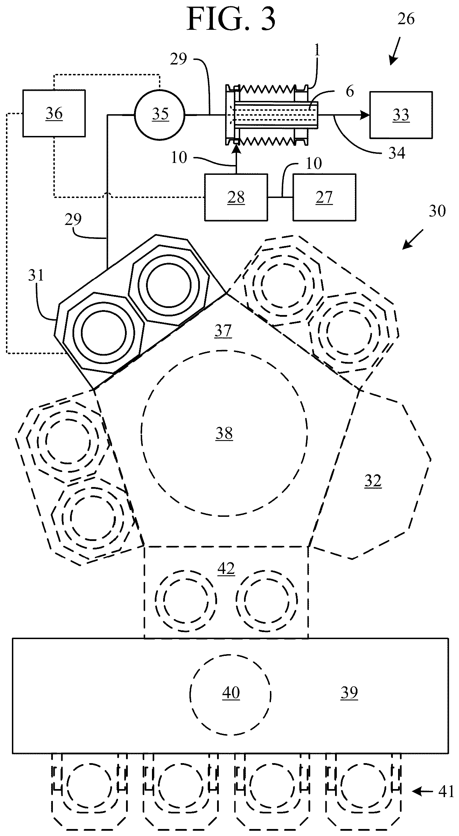

FIG. 3 schematically illustrates a processing apparatus 26 according to an embodiment. The processing apparatus 26 of the embodiment of FIG. 3 comprises a bellows joint fitting 1 in accordance with the first aspect. Unless explicitly stated otherwise, the processing apparatus 26 of the embodiment of FIG. 3 may or may not comprise any feature(s) disclosed within this specification, mutatis mutandis. Other embodiments may or may not be identical or similar to the embodiment of FIG. 3.

The processing apparatus 26 of the embodiment of FIG. 3 comprises a dilution fluid source 27 for providing dilution fluid 10 into the bellows joint fitting 1 via one or more fluid inlets of the bellows joint fitting 1. For clarity, the one or more fluid inlets have been omitted from FIG. 3. In other embodiments, a processing apparatus may or may not be comprise a dilution fluid source for providing dilution fluid into a bellows joint fitting via one or more fluid inlets thereof.

In the embodiment of FIG. 3, the processing apparatus 26 comprises a mass flow controller 28 for controlling dilution fluid flow into the bellows joint fitting 1 via the one or more fluid inlets of the bellows joint fitting 1. In some embodiments, a processing apparatus comprising such a mass flow controller may facilitate reducing the consumption of dilution fluid while increasing the operational lifetime of a bellows joint fitting. Additionally or alternatively, a processing apparatus comprising such a mass flow controller may facilitate measuring fluid conductance via at least part of one or more fluid inlets. In other embodiments, a processing apparatus may or may not comprise a mass flow controller for controlling dilution fluid flow into a bellows joint fitting via one or more fluid inlets thereof. In some embodiments a processing apparatus may comprise one or more fluid flow control valves, such as one or more needle valves, one or more globe valves, and/or one or more diaphragm valves, in addition to or as an alternative to a mass flow controller for controlling dilution fluid flow into a bellows joint fitting via one or more fluid inlets thereof.

In the embodiment of FIG. 3, the processing apparatus 26 comprises one or more process units 30 and an upstream exhaust network 29 fluidically coupling the one or more process units 30 and the bellows joint fitting 1 for transporting process exhaust effluent 6 from the one or more process units 30 into the bellows joint fitting 1. In FIG. 3, the one or more process units 30 is shown to comprise a single process unit drawn with solid lines; however, the one or more process units 30 may optionally comprise additional process units, as depicted using dashed lines in FIG. 3. What is stated throughput this specification in relation to the one or more process units 30 may apply, mutatis mutandis, to any or all process units thereof, for example, the single process unit drawn with solid lines and any of the additional process units depicted using dashed lines. In other embodiments, a processing apparatus may or may not comprise one or more process units and an upstream exhaust network fluidically coupling the one or more process units and a bellows joint fitting for transporting process exhaust effluent from the one or more process units into the bellows joint fitting.

The one or more process units 30 of the embodiment of FIG. 3 may comprise one or more chemical vapor deposition units 31, at least part of which may or may not be implemented as atomic layer deposition units, and one or more dry etching units 32, at least part of which may or may not be implemented as precleaning units. In other embodiments, one or more process units may comprise any suitable type(s) of process units, for example, one or more chemical vapor deposition units, e.g., one or more atomic layer deposition units; and/or one or more dry etching units; and/or one or more diffusion furnace units.

The one or more process units 30 of the embodiment of FIG. 3 may be implemented as single-substrate process units. In other embodiments, wherein a processing apparatus comprises one or more process units, the one or more process units may be implemented as any suitable type(s) of process units, for example, as single-substrate process units and/or multi-substrate process units, such as batch furnaces, or the like.

In the embodiment of FIG. 3, the processing apparatus 26 comprises a vacuum pump 35 upstream of the bellows joint fitting 1 for driving the process exhaust effluent 6 via the bellows joint fitting 1. In other embodiments, a processing apparatus may or may not comprise a vacuum pump upstream of a bellows joint fitting for driving process exhaust effluent via the bellows joint fitting. In embodiments, wherein a processing apparatus comprises a bellows joint fitting and a vacuum pump, the vacuum pump may be arranged in any suitable manner with respect to the bellows joint fitting. For example, in some embodiments, wherein a processing apparatus comprises a bellows joint fitting and a vacuum pump, the bellows joint fitting may be arranged upstream of the vacuum pump. In some such embodiments, the processing apparatus may further comprise a second bellows joint fitting downstream of the vacuum pump.

The processing apparatus 26 of the embodiment of FIG. 3 comprises an abatement unit 33 and a downstream exhaust network 34 fluidically coupling the bellows joint fitting 1 and the abatement unit 33 for transporting the process exhaust effluent 6 from the bellows joint fitting 1 to the abatement unit 33. The abatement unit 33 is arranged downstream of the bellows joint fitting 1. In other embodiments, a processing apparatus may or may not comprise an abatement unit. In embodiments, wherein a processing apparatus comprises an abatement unit, the processing apparatus may or may not comprise a downstream exhaust network fluidically coupling a bellows joint fitting and the abatement unit. In other embodiments, wherein a processing apparatus comprises an abatement unit, the abatement unit may be arranged in any suitable manner with respect to a bellows joint fitting, for example, upstream or downstream of the bellows joint fitting, or otherwise.

In the embodiment of FIG. 3, the processing apparatus 26 further comprises a control unit 36 configured to operate the processing apparatus 26 for executing a method in accordance with the second aspect. To this end, the control unit 36 is operationally coupled at least to at least part of the one or more process units 30, the mass flow controller 28, and the vacuum pump 35 to control the transport of the process exhaust effluent 6 from the one or more process units 30 into the bellows joint fitting 1 and to adjust dilution fluid flow into the bellows joint fitting 1 via the one or more fluid inlets thereof, as schematically indicated in FIG. 3 using dotted arrows. In other embodiments, a processing apparatus may or may not comprise a control unit configured to operate the processing apparatus for executing a method in accordance with the second aspect. In embodiments, wherein a processing apparatus comprises a control unit configured to operate the processing apparatus for executing a method in accordance with the second aspect, the control unit may be operationally coupled to any device(s) and/or unit(s) necessary or beneficial for operating the processing apparatus 26 for executing a method in accordance with the second aspect. In some such embodiments, the control unit may be operationally coupled to at least part of one or more process units, a mass flow controller, and/or a vacuum pump, for example, to control transport of process exhaust effluent from the one or more process units into a bellows joint fitting and/or to adjust dilution fluid flow into the bellows joint fitting via one or more fluid inlets thereof.

In the embodiment of FIG. 3, the processing apparatus 26 may be implemented as a semiconductor processing apparatus. In other embodiments, a processing apparatus may or may not be implemented as a semiconductor manufacturing apparatus. For example, in some embodiments, a processing apparatus may be implemented as a processing apparatus for depositing protective coatings, for example, moisture barrier coatings, gas diffusion barrier coatings, and/or abrasion-resistant coatings; as a processing apparatus for metal refining; as a waste processing apparatus; or as a chemical manufacturing apparatus.

As indicated in FIG. 3 using dashed arrows, the processing apparatus 26 of the embodiment of FIG. 3 may further comprise a wafer transfer chamber 37, which is connected to the one or more process units 30 and may or may not be provided with a back-end wafer transfer robot 38; an equipment front-end module 39, which may or may not be provided with front-end wafer transfer robot 40 and/or one or more wafer load ports 41; and/or a load lock module 42 connecting the equipment front-end module 39 and the wafer transfer chamber 37 to enable wafer transfer therebetween.

The example embodiments of the disclosure described above do not limit the scope of the invention, since these embodiments are merely examples of the embodiments of the invention, which is defined by the appended claims and their legal equivalents. Any equivalent embodiments are intended to be within the scope of this invention. Indeed, various modifications of the disclosure, in addition to those shown and described herein, such as alternative useful combinations of the elements described, may become apparent to those skilled in the art from the description. Such modifications and embodiments are also intended to fall within the scope of the appended claims.

## Claims

1. A bellows joint fitting having an upstream end for accepting process exhaust effluent and a downstream end for discharging the process exhaust effluent, the bellows joint fitting comprising a bellows pipe and one or more fluid inlets for introducing dilution fluid to be discharged via the downstream end with the process exhaust effluent.

2. A bellows joint fitting according to claim 1, wherein the bellows joint fitting comprises an inner pipe coupled to and surrounded by the bellows pipe for shielding the bellows pipe from the process exhaust effluent.

3. A bellows joint fitting according to claim 2, wherein the bellows pipe has a first bellows pipe end, and the bellows joint fitting comprises an annular body connecting the first bellows pipe end to the inner pipe, at least part of the one or more fluid inlets extending inside the annular body.

4. A bellows joint fitting according to claim 2 or 3, wherein an annular intermediate space surrounded by the bellows pipe surrounds the inner pipe, and the one or more fluid inlets comprises one or more first fluid inlets configured to introduce the dilution fluid into the intermediate space.

5. A bellows joint fitting according to any of claims 2 to 4, wherein a fluid flow path surrounded by the inner pipe extends from the upstream end to the downstream end, and the one or more fluid inlets comprises one or more second fluid inlets configured to introduce the dilution fluid into the fluid flow path.

6. A method for treatment of process exhaust effluent, comprising:
- providing a bellows joint fitting in accordance with any of the preceding claims,
- accepting the process exhaust effluent into the bellows joint fitting via its upstream end,
- introducing dilution fluid into the bellows joint fitting via its one or more fluid inlets, and
- discharging the process exhaust effluent and the dilution fluid from the bellows joint fitting via its downstream end.

7. A method according to claim 6, wherein accepting the process exhaust effluent comprises receiving the process exhaust effluent from a processing apparatus.

8. A method according to claim 6 or 7, wherein the method comprises feeding the process exhaust effluent and the dilution fluid into an abatement unit.

9. A method according to any of claims 6 to 8, wherein the method comprises measuring fluid conductance via at least part of the one or more fluid inlets to form a measurement result and, if the fluid conductance represented by the measurement result exceeds a pre-determined fluid conductance threshold value, raising an alarm and/or triggering an automated corrective procedure.

10. A method according to any of claims 6 to 9, wherein the process exhaust effluent accepted into the bellows joint fitting comprises one or more inorganic acids in gaseous form.

11. A method according to any of claims 6 to 10, wherein the dilution fluid comprises nitrogen gas.

12. A processing apparatus, comprising a bellows joint fitting in accordance with any of claims 1 to 5.

13. A processing apparatus according to claim 12, wherein the processing apparatus comprises a dilution fluid source for providing the dilution fluid into the bellows joint fitting via the one or more fluid inlets thereof.

14. A processing apparatus according to claim 12 or 13, wherein the processing apparatus comprises a mass flow controller for controlling dilution fluid flow into the bellows joint fitting via the one or more fluid inlets thereof.

15. A processing apparatus according to any of claims 12 to 14, wherein the processing apparatus comprises one or more process units and an upstream exhaust network fluidically coupling the one or more process units and the bellows joint fitting for transporting process exhaust effluent from the one or more process units into the bellows joint fitting.

16. A processing apparatus according to claim 15, wherein the one or more process units comprises one or more chemical vapor deposition units, e.g., one or more atomic layer deposition units; and/or one or more dry etching units; and/or one or more diffusion furnace units.

17. A processing apparatus according to any of claims 12 to 16, wherein the processing apparatus comprises a vacuum pump upstream of the bellows joint fitting for driving the process exhaust effluent via the bellows joint fitting.

18. A processing apparatus according to any of claims 12 to 17, wherein the processing apparatus comprises an abatement unit and a downstream exhaust network fluidically coupling the bellows joint fitting and the abatement unit for transporting the process exhaust effluent from the bellows joint fitting to the abatement unit.

19. A processing apparatus according to any of claims 12 to 18, wherein the processing apparatus comprises a control unit configured to operate the processing apparatus for executing a method in accordance with any of claims 6 to 11.
